# EUROPEAN PATENT APPLICATION

(11) **EP 2 202 008 A1**
(43) Date of publication of application: **30.06.2010**
(21) Application number: 08838953.1
(22) Date of filing: 07.10.2008
(51) Int. Cl.: B08B 3/08, B08B 3/04

(54) **METHOD FOR CLEANING HEAT MODE TYPE RECORDING MEDIUM LAYER, METHOD FOR MANUFACTURING PRODUCT HAVING RECESS AND PROJECTION, METHOD FOR MANUFACTURING LIGHT EMITTING ELEMENT AND METHOD FOR MANUFACTURING OPTICAL ELEMENT**

(30) Priority: 15.10.2007 JP 2007267664
(71) Applicant: Fujifilm Corporation, Tokyo 106-8620 (JP)
(72) Inventor: USAMI, Yoshihisa, Ashigarakami-gun Kanagawa 258-8577 (JP)
(74) Representative: Klunker . Schmitt-Nilson . Hirsch
(86) International application number: PCT/JP2008/002818
(87) International publication number: WO 2009/050858

(57) **Abstract**

A method for cleaning a heat mode type recording material layer to remove debris (D) generated when a plurality of recessed portions (15) are formed in a thermally deformable heat mode recording material layer (12) by application of condensed light is provided, which method includes using a liquid (L) inactive to the recording material layer (12), to thereby remove the debris (D). This method for cleaning a heat mode type recording material layer is applicable to a method for manufacturing a pit-projection product, a method for manufacturing a light emitting element, and a method for manufacturing an optical element.

## Description

### TECHNICAL FIELD

The present invention relates to a method for cleaning a heat mode type recording material layer to remove debris generated when recessed portions are formed in the heat mode type recording material layer, and methods for manufacturing a pit-projection product, for manufacturing a light emitting element and for manufacturing an optical element, using the method.

### BACKGROUND ART

Among hitherto known methods for forming pits and projections in a predetermined target object such as an optical disc, a master disc for manufacturing an optical disc and a light emitting element having a light emitting surface formed with pits and projections is a method in which a photoresist is used as described, for example, in JP 7-161080 A. To be more specific, this method comprises an application step in which a photoresist is applied to a master disc, a light exposure step in which the photoresist is exposed to a laser beam, a development step in which an exposed portion is removed with a developing solution to form predetermined recessed portions, an etching step in which a reactive ion etching (hereinafter referred to as "RIE") is performed to etch the master disc, and a stripping step in which a residual resist is stripped off, whereby pits and projections are formed in the master disc.

### DISCLOSURE OF INVENTION

The inventor of the present application has devised a method for forming pits and projections, which may be better than the prior art method utilizing a photoresist and RIE. To be more specific, the method comprises etching using a heat mode resist material in which holes are formed by application of a condensed laser beam, instead of the aforementioned photoresist. In this method, by a simple step of a laser beam illumination, recessed portions are formed in its illuminated portions, and thus the development step as conventionally required is not necessitated, so that the time required for production can be shortened.

However, in the aforementioned method using a heat mode resist material, the portions illuminated with a laser beam undergo chemical or/and physical change(s) such as decomposition, sublimation, vaporization, scattering, etc., to have holes formed therein, and debris are generated during these changes. Therefore, the debris, if left around the holes formed in the heat mode resist material, would prevent the subsequent etching process from going under good conditions, which would disadvantageously produce the problem that a neat pattern of pits and projections could not be formed.

The inventor of the present application also conceives an idea of forming pits and projections without etching, wherein a heat mode resist material in which recessed portions are formed by application of a laser beam is retained as it is. In this approach, as well, the debris left around the holes as described above would raise the same problem that a neat pattern of pits and projections could not be formed.

With this in view, it is an object of the present invention to provide a method for cleaning a heat mode type recording material layer, which may contribute to formation of a neat pattern of pits and projections, by removing debris generated when recessed portions are formed in the heat mode type recording material layer, and methods for manufacturing a pit-projection product, for manufacturing a light emitting element and for manufacturing an optical element, using the method.

The present invention, which may solve the above-described problems, includes a method for cleaning a heat mode type recording material layer to remove debris generated when a plurality of recessed portions are formed in a thermally deformable heat mode recording material layer by application of condensed light, in which a liquid inactive to the recording material layer is used to thereby remove the debris.

According to this aspect of the present invention, even if debris are generated when recessed portions are formed by application of condensed light in the recording material layer, the debris are removed by the liquid. Here, since the liquid is inactive to the recording material layer, the portions, other than the recessed portions, of the recording material layer are left in good condition, and thus a neat pattern of pits and projections are formed with this recording material layer. Also, when the recording material layer thus left in good condition is used for etching as a mask, the recording material layer functions well as a mask, and thus a neat pattern of pits and projections can be formed in the portions subjected to etching.

Optionally, according to the present invention, a period of time elapsing from a time at which the recessed portions have been formed to a time at which removal of the debris is started may be in the range of 0.1 second to 72 hours.

With this feature, it is after the elapse of 0.1 second or later from the time at which the recessed portions have been formed that the removal of debris is carried out, and thus the recording material layer in which the recessed portions have been formed can be cooled sufficiently. Therefore, the disturbance of the shape of the recessed portions which would be caused by putting a liquid on the high-temperature recording material layer can be suppressed. Moreover, since the removal of debris is carried out within 72 hours after the time at which the recessed portions have been formed, the possibility of fixation of the debris on the recording material layer is reduced, and thus the debris can be removed effectively by the liquid.

Optionally, according to the present invention, the liquid may be configured to contain at least one of hydrocarbon solvents, fluorinated solvents and water.

Further, it may be provided according to the present invention that after the liquid is supplied onto the recording material layer, the recording material layer is turned along a surface thereof, to thereby wash the debris away from inside to outside of the recording material layer by the liquid.

With this feature, supplying the liquid onto the recording material layer and thereafter turning the recording material layer causes the liquid on the recording material layer to move from inside to outside by centrifugal force. Then, the thus-moving liquid forces the debris to be washed away from inside to outside, so that the debris can be removed effectively from the recording material layer.

Further, it may be provided according to the present invention that the liquid is supplied onto part of the recording material layer while the recording material layer is turned along a surface thereof, to thereby wash the debris away from inside to outside of the recording material layer by the liquid.

With this feature, the liquid can be evenly spread over the entire surface of the recording material layer only by supplying the liquid onto part of the recording material layer, which may be located near the center of rotation thereof, and thus the amount of liquid to be applied to the entire surface of the recording material layer can be reduced. Moreover, the rotation causes the liquid to make a movement which in turn causes the debris to be washed away. Therefore, when the liquid is applied over the entire surface of the recording material layer in this way, the application step and the step of washing away the debris are performed at the same time, and thus the cleaning time can be shortened.

In the present invention, after washing the debris away, the recording material layer may continue to be turned, whereby the recording layer is dried.

With this feature, by continuing to turn the recording material layer and thereby drying the recording material layer, the recording material layer can be dried more swiftly than that which is to be air-dried by the method comprising stopping the rotation after washing the debris away.

The method for cleaning a heat mode type recording material layer according to the aspects of the present invention as described above may be utilized in a method for manufacturing a pit-projection product such as an optical disc or a semiconductor, a method for manufacturing a light emitting element, and a method for manufacturing an optical element.

According to the present invention, the debris generated when the recessed portions are formed in the heat mode type recording material layer are removed by the liquid which is inactive to the recording material layer, and thus a neat pattern of pits and projections can be formed therein.

### BRIEF DESCRIPTION OF THE DRAWINGS

FIG. 1 (a) is a diagram showing an LED package, and (b) is an enlarged view of (a).
FIG. 2 (a) is a diagram showing one example of a light emission surface as seen in plan view, and (b) is a diagram showing another example of a light emission surface as seen in plan view.
FIG. 3 (a) is a diagram explaining a relation between diameter and pitch of recessed portions, and (b) is a diagram explaining a relation between light-emitting time and period of a laser beam.
FIGS. 4 (a)-(c) are diagrams showing a process for manufacturing an LED package.
FIGS. 5 (a)-(c) are diagrams showing a cleaning process.
FIG. 6 is a diagram showing a method for manufacturing an optical element according to a second embodiment.
FIGS. 7 (a)-(c) are diagrams showing a process for manufacturing an LED element according to a third embodiment.
FIG. 8 (a) is a perspective view of an optical disc manufactured by a manufacturing method which comprises a cleaning method according to the present invention, and (b) is a sectional view thereof.
FIGS. 9 (a)-(c) are diagrams showing an embodiment in which a barrier layer forming step is omitted from the manufacturing process according to the first embodiment.
FIGS. 10 (a)-(d) are diagrams showing an embodiment as implemented with modifications made to the process of manufacturing an LED element according to the third embodiment.

### BEST MODES FOR CARRYING OUT THE INVENTION

### [FIRST EMBODIMENT]

Next, a method for manufacturing a light emitting element according to the present invention will be described with reference to the drawings.

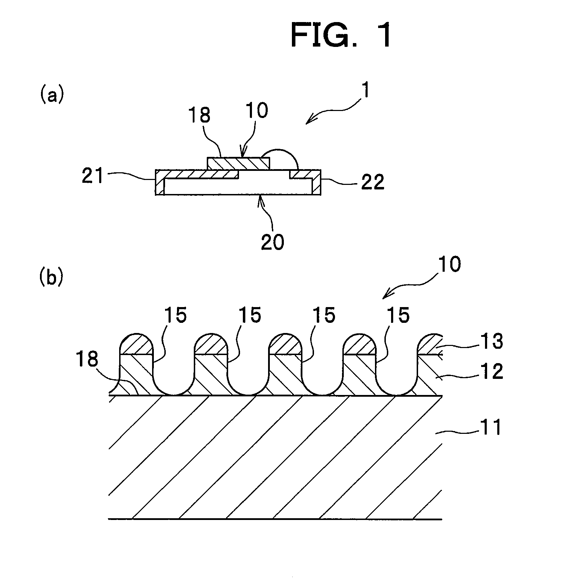

As shown in FIG. 1 (a), an LED package 1 as an example of a light emitting element according to this embodiment comprises an LED element 10 as an example of a luminous body, and a case 20 for fixing and wiring the LED element 10.

The LED element 10 is a conventionally known element. Although not shown in detail in the drawings, the LED element 10 includes an n-type cladding layer, a p-type cladding layer, and an active layer. In FIG. 1 (a), an upper surface is a light emission surface 18, from which light is emitted to the outside.

The LED element 10 is fixed to the case 20. The case 20 is provided with wiring 21, 22 for supplying electric power to the LED element 10.

As shown in FIG. 1 (b), the LED element 10 includes a light emitting portion 11 which is a main body portion for emitting light, a recording material layer 12 formed on the light emitting portion 11 (a light emission surface 18), and a barrier layer 13 in this order.

The recording material layer 12 is a layer in which a recessed portion can be formed by application of strong light, through thermal deformation of material caused by heat produced by conversion of the light applied, that is, a layer of a so-called heat mode type recording material. This type of recording material is hitherto used generally in the recording layer of optical discs or the like; for example, recording materials such as cyanine-based, phthalocyanine-based, quinone-based, squarylium-based, azulenium-based, thiol complex salt-based, and merocyanine-based recording materials may be used for our purpose.

The recording material layer 12 according to the present invention may preferably be of a dye type, which contains a dye as a recording substance.

Therefore, the recording substance contained in the recording material layer 12 may be selected from dyes or other organic compounds. It is to be understood that the material which may be used for the recording material layer 12 is not limited to organic matter; that is, an inorganic material or a composite material of organic and inorganic materials may also be employed. With the organic materials, however, the coating process for forming a film can be performed easily by spin coating, and a material having a lower transition temperature is readily available; thus, the organic materials may be preferable. Further, amongst various organic materials, dyes whose light absorption can be controlled by varying their molecular design may be preferable.

Preferred examples of material for use in the recording material layer 12 may include methine dyes (cyanine dyes, hemicyanine dyes, styryl dyes, oxonol dyes, merocyanine dyes, etc.), large ring dyes (phthalocyanine dyes, naphthalocyanine dyes, porphyrin dyes, etc.), azo dyes (including an azo-metal chelate dye), arylidene dyes, complex dyes, coumarin dyes, azole derivatives, triazine derivatives, 1-aminobutadiene derivatives, cinnamic acid derivatives, quinophthalone dyes, etc.

Of these, a dye-type recording material 12 in which information can be recorded only once with a laser beam may be preferable. This is because such an organic recording material can be dissolved in a solvent and formed into a film by spin coating or spray coating, and therefore excels in productivity. This dye-type recording material 12 may preferably contain a dye having absorption in the range of recording wavelengths. Particularly, the upper limit of an extinction coefficient k indicating the amount of light absorption may preferably be 10 or less, more preferably 5 or less, still more preferably 3 or less, and most preferably 1 or less. This is because too high extinction coefficient k would prevent light incident on one side of the recording material layer 12 from reaching or passing through the opposite side, thus rendering the holes formed in the recording material layer 12 uneven. On the other hand, the lower limit of the extinction coefficient k may preferably be 0.0001 or more, more preferably 0.001 or more, and still more preferably 0.1 or more. This is because too low extinction coefficient k would reduce the amount of light absorption, which would require higher laser power and reduce the production speed.

It is to be understood, as described above, that the recording material layer 12 needs to have absorption of light in the range of recording wavelengths; with this in view, the selection of an appropriate dye and/or alteration of its structure may be made in accordance with the wavelength of the laser beam produced by the laser light source.

For example, in the case where the oscillation wavelength of the laser beam emitted from the laser light source is around 780 nm, it is advantageous to select dyes such as pentamechine cyanine dyes, heptamechine oxonol dyes, pentamethine oxonol dyes, phthalocyanine dyes, and naphthalocyanine dyes.

In the case where the oscillation wavelength of the laser beam emitted from the laser light source is around 660 nm, it is advantageous to select dyes such as trimechine cyanine dyes, pentamethine oxonol dyes, azo dyes, azo-metal complex dyes, and pyrromethene complex dyes.

Further, in the case where the oscillation wavelength of the laser beam emitted from the laser light source is around 405 nm, it is advantageous to select dyes such as monomechine cyanine dyes, monomechine oxonol dyes, zero-mechine merocyanine dyes, phthalocyanine dyes, azo dyes, azo-metal complex dyes, porphyrin dyes, arylidene dyes, complex dyes, coumarin dyes, azole derivatives, triazine derivatives, benzotriazole derivatives, 1-aminobutadiene derivatives, and quinophthalone dyes.

Examples of preferred compounds for use in the recording material layer 12 *(i.e.,* as a recording layer compound) are shown below in the cases where the oscillation wavelength of the laser beam emitted from the laser light source is around 780 nm (near-infrared range of laser wavelengths), around 660 nm (visible-light range of laser wavelengths, particularly, red-color range of laser wavelengths), and around 405 nm (near-ultraviolet range of laser wavelengths), respectively. Compounds given by (I-1) to (I-10) in the following chemical formulae 1, 2 are suitable in the case where the oscillation wavelength of the laser beam is around 780 nm. Compounds given by formulae (II-1) to (II-8) in the chemical formulae 3, 4 are suitable in the case where the oscillation wavelength of the laser beam is around 660 nm, and compounds given by (III-1) to (III-14) in the chemical formulae 5, 6 and a compound given in the chemical formula 7 are suitable in the case where the oscillation wavelength of the laser beam is around 405 nm. It is to be understood that the present invention is not limited to the case where these compounds are used as the recording layer compound.

Examples of recording layer compound in the case of oscillation wavelength around 780 nm

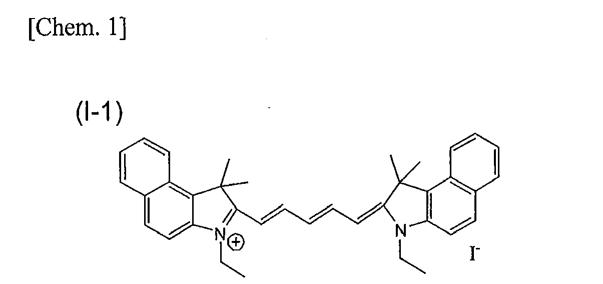

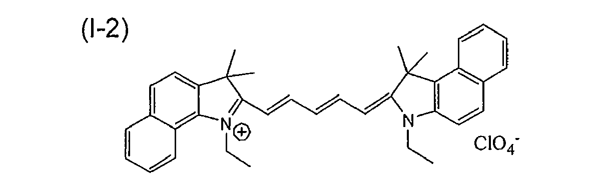

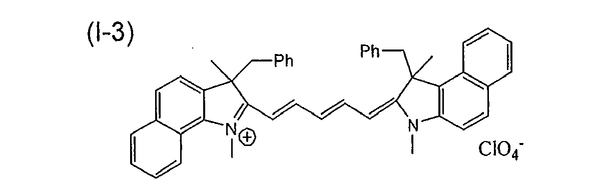

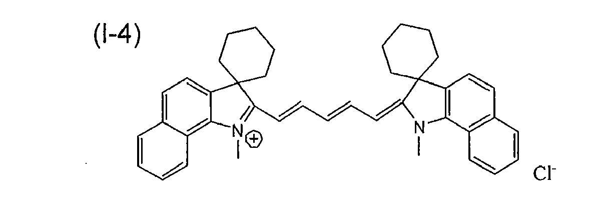

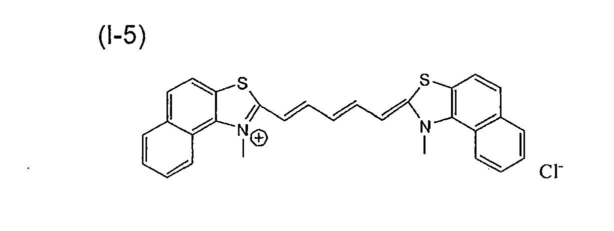

Examples of recording layer compound in the case of oscillation wavelength around 780 nm

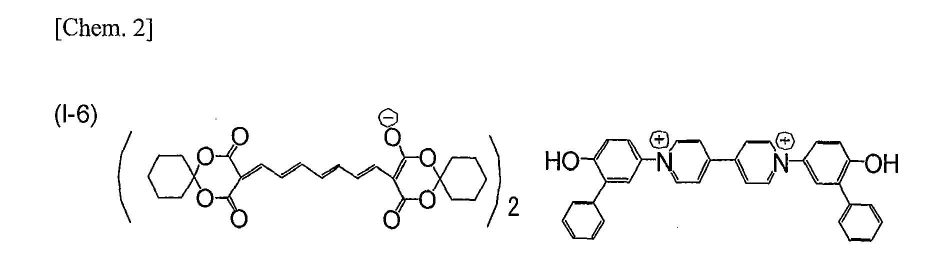

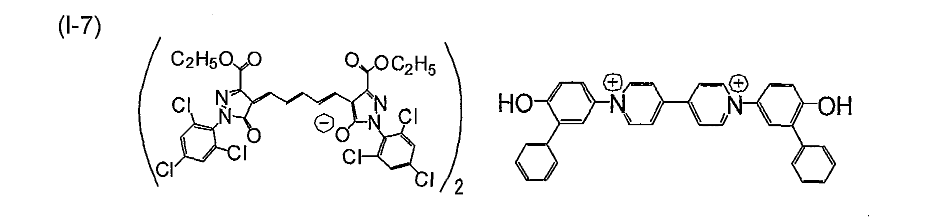

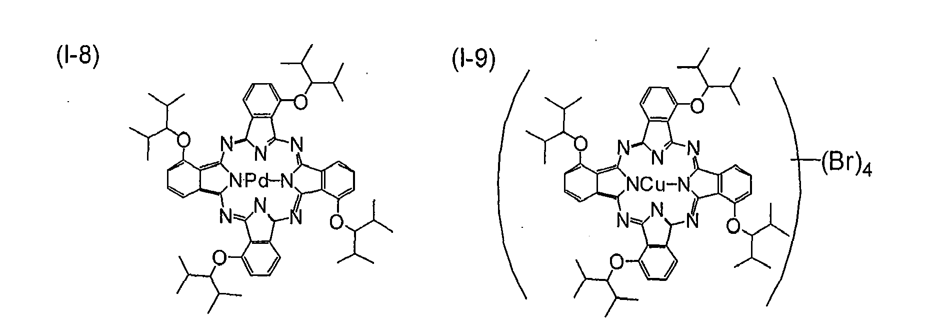

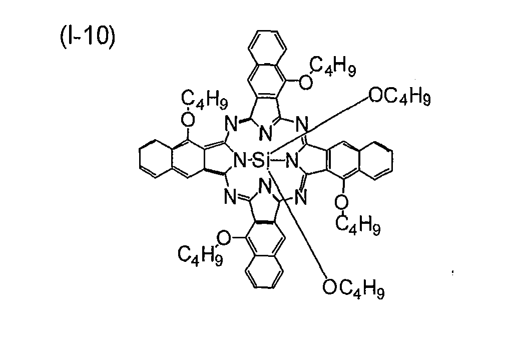

Examples of recording layer compound in the case of oscillation wavelength around 660 nm

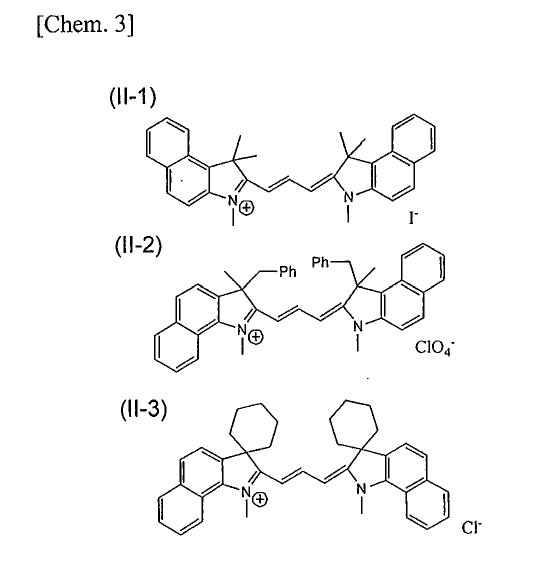

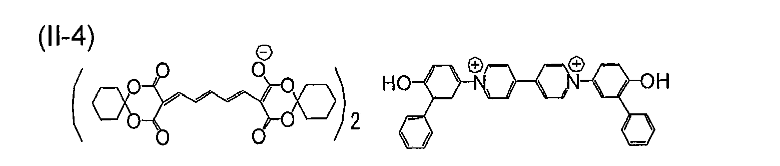

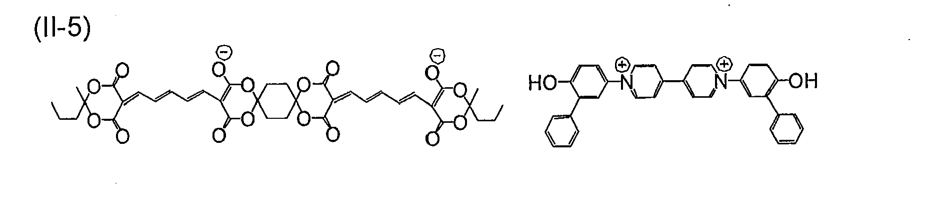

Examples of recording layer compound in the case of oscillation wavelength around 660 nm

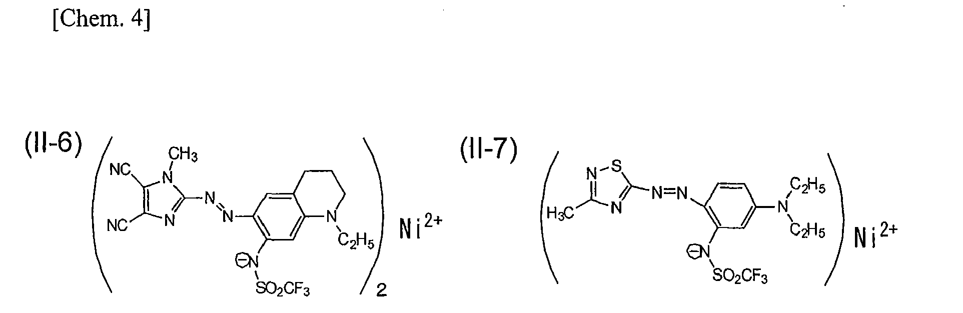

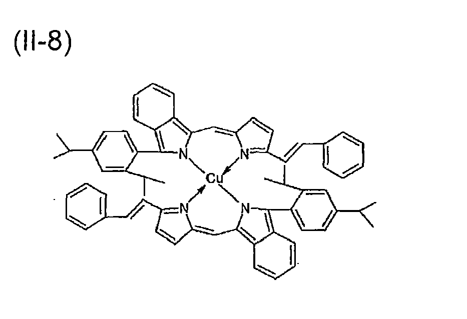

Examples of recording layer compound in the case of oscillation wavelength around 405 nm

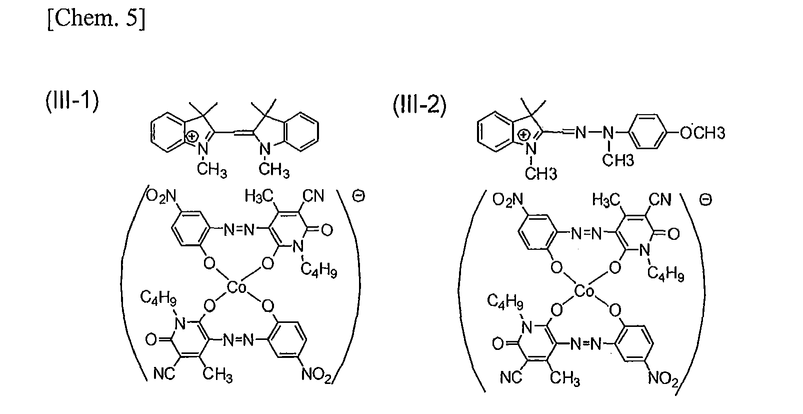

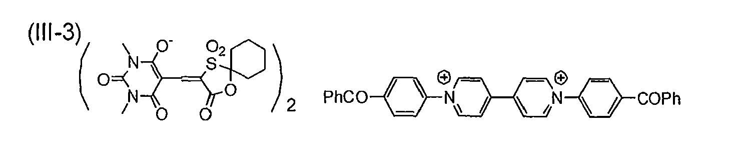

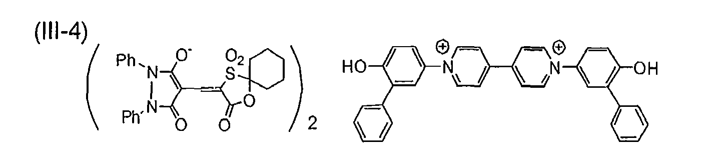

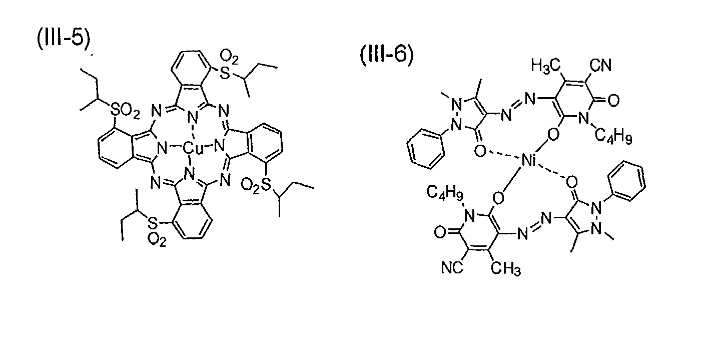

Examples of recording layer compound in the case of oscillation wavelength around 405 nm

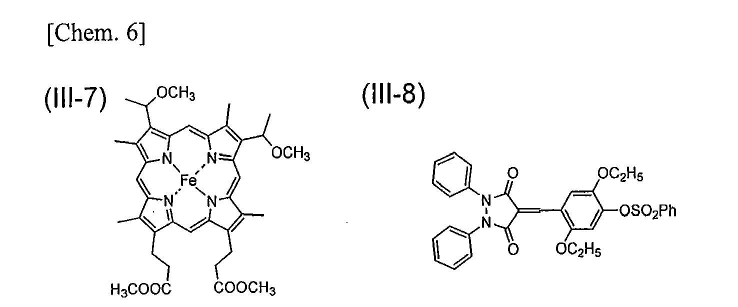

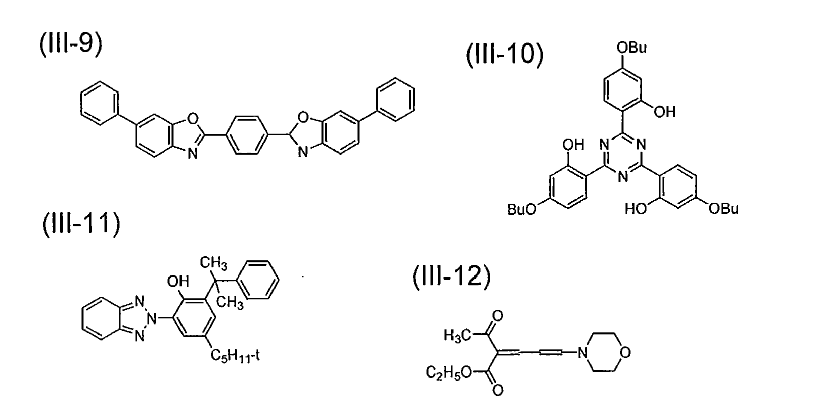

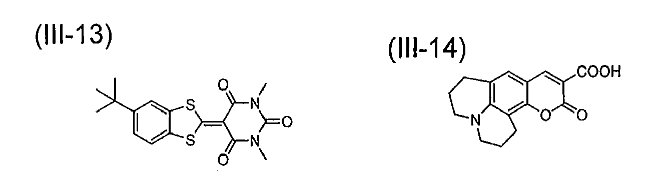

Examples of recording layer compound in the case of oscillation wavelength around 405 nm

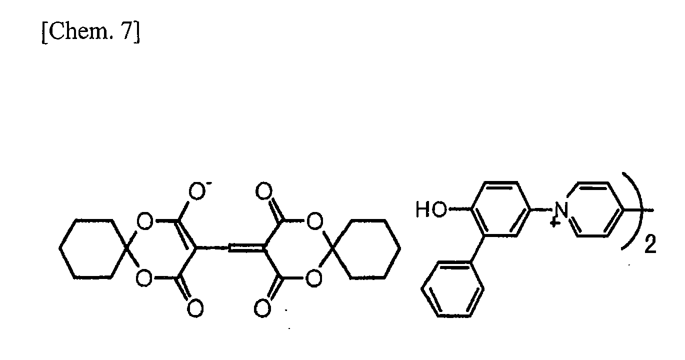

Dyes described in Japanese Laid-open Patent Applications, Publication (JP-A) Nos. 4-74690, 8-127174, 11-53758, 11-334204, 11-334205, 11-334206, 11-334207, 2000-43423, 2000-108513, and 2000-158818 can also preferably be used.

The dye-type recording material layer 12 may be formed by dissolving a dye in an adequate solvent along with a binding agent to prepare a coating liquid, then applying the coating liquid on a substrate to form a coating film, and thereafter drying the resulting coating film. In this process, the temperature of a surface on which the coating liquid is applied may preferably be in the range of 10-40 degrees centigrade. More preferably, the lower limit thereof may be 15 degrees centigrade or higher, still more preferably 20 degrees centigrade or higher, and particularly preferably 23 degrees centigrade or higher. Meanwhile, the upper limit of the surface may be more preferably 35 degrees centigrade or lower, still more preferably 30 degrees centigrade or lower, and particularly preferably 27 degrees centigrade or lower. When the temperature of the coated surface is in the above ranges, uneven application of the coating and coating failure can be prevented, so that a thickness of the coating film can be made uniform.

Each of the upper and lower limits mentioned above may be arbitrarily combined with each other.

Here, the recording material layer 12 may be either mono-layered or multi-layered. In the case of the recording material layer 12 having a multi-layered configuration, the coating step is repeated plural times.

A concentration of the dye in the coating liquid is generally in the range of 0.01-30 mass percent, preferably in the range of 0.1-20 mass percent, more preferably in the range of 0.5-10 mass percent, and most preferably in the range of 0.5-3 mass percent.

Examples of the solvent for the coating liquid include: esters such as butyl acetate, ethyl lactate and cellosolve acetate; ketones such as methyl ethyl ketone, cyclohexanone, and methyl isobutyl ketone; chlorinated hydrocarbons such as dichloromethane, 1,2-dichloroethane and chloroform; amides such as dimethylformamide; hydrocarbons such as methylcyclohexane; ethers such as tetrahydrofuran, ethyl ether, and dioxane; alcohols such as ethanol, n-propanol, isopropanol, n-butanol, and diacetone alcohol; fluorinated solvents such as 2,2,3,3-tetrafluoropropanol; and glycol ethers such as ethylene glycol monomethyl ether, ethylene glycol monoethyl ether and propylene glycol monomethyl ether.

Taking the solubility of the dye used in the solvents into consideration, the above solvents may be used singly or in a combination of two or more kinds thereof. Various kinds of additives such as an antioxidant, a UV absorbent, a plasticizer and a lubricant may be added in the coating liquid depending on the purpose.

Coating methods such as spray method, spin coating method, dip method, roll coat method, blade coat method, doctor roll method, doctor blade method, and screen printing method are applicable. Of these methods, the spin coat method is preferable in terms of its excellent productivity and easy controllability of the film thickness.

In order to form the recording material layer 12 (recording layer compound) better by the spin coating method, the dye may be dissolved preferably in the organic solvent in the range of 0.01-30 weight percent, and more preferably in the range of 0.1-20 weight percent. It is particularly preferable that the dye be dissolved in tetrafluoropropanol in the range of 0.5-10 weight percent. It is also preferable that the thermal decomposition temperature of the recording layer compound be in the range of 150-500 degrees centigrade, and more preferably in the range of 200-400 degrees centigrade.

The temperature of the coating liquid at the time of coating may preferably be in the range of 23-50 degrees centigrade, more preferably in the range of 24-40 degrees centigrade, and particularly preferably in the range of 25-30 degrees centigrade.

In the spin coating method, the substrate is rotated at the outset, and a coating liquid is discharged onto the rotating substrate. The rotation speed at this step may be preferably in the range of 20-700 rpm, more preferably in the range of 50-500 rpm, and still more preferably in the range of 100-400 rpm. The rotation speed at the subsequent drying step may preferably be in the range of 500-10,000 rpm, more preferably in the range of 1,000-7,000 rpm, and still more preferably in the range of 2,000-5,000 rpm.

In the case where the coating liquid contains a binding agent, examples of the binding agent include natural organic polymers such as gelatin, cellulose derivatives, dextran, rosin and rubber; and synthetic organic polymers including hydrocarbonic resins such as polyethylene, polypropylene, polystylene and polyisobutylene, vinyl resins such as polyvinylchloride, polyvinylidene chloride and polyvinylchloride-polyvinyl acetate copolymers, acrylic resins such as polymethyl acrylate and polymethyl methacrylate, and initial condensates of thermosetting resins such as polyvinyl alcohol, chlorinated polyethylene, epoxy resin, butyral resin, rubber derivatives and phenol formaldehyde resin. In the case
where the binding agent is used together as a material for the recording material layer 12, the amount of the binding agent used is generally in the range of 0.01-50 times the amount of dye (mass ratio), and preferably in the range of 0.1-5 times the amount of dye (mass ratio).

In order to increase the lightfastness of the recording material layer 12, various antifading agents may be contained in the recording material layer 12.

In general, a singlet oxygen quencher is used for the antifading agent. As examples of such singlet oxygen quencher, those described in published documents such as patent specifications hitherto known in the art can be used.

Specific examples of such patent specifications include: Japanese Laid-open Patent Applications, Publication (JP-A) Nos. 58-175693, 59-81194, 60-18387, 60-19586, 60-19587, 60-35054, 60-36190, 60-36191, 60-44554, 60-44555, 60-44389, 60-44390, 60-54892, 60-47069, 63-209995, and 4-25492; Japanese Examined Patent Applications, Publication (JP-B) Nos. 1-38680 and 6-26028; German Patent No. 350399; and Nippon Kagaku Kaishi, October (1992), p. 1141. The use amount of the antifading agent such as a singlet oxygen quencher relative to the amount of dye is generally in the range of 0.1-50 mass percent, preferably in the range of 0.5-45 mass percent, more preferably in the range of 3-40 mass percent, and particularly preferably in the range of 5-25 mass percent.

The above description refers to a solvent coating method adopted in the case where the recording material layer 12 is a dye-type recording layer; however, the recording material layer 12 may also be formed by any of other film-forming methods such as evaporation, sputtering and CVD, which may be selected depending on the physical properties of the recording material to be used therein.

The dye to be used is such that a light absorptance thereof at the wavelength of a laser beam used in the processing of the recessed portions 15 which will be described later is higher than those at the other wavelengths. It is particularly preferable that the light absorptance at the wavelength of the laser beam in the processing be higher than the emission wavelength of a light emitting element such as the LED element 10.

The wavelength at which the dye exhibits the peak absorption may not necessarily fall within the range of the wavelengths of visible light, but may be within the range of the wavelengths of the ultraviolet or infrared region.

Particularly, when the refractive index of the material constituting the light emission surface of the light emitting element is high, it is preferable that the recording material layer 12 and the barrier layer 13, which constitute the recessed portions 15, have higher refractive index.

The dye has a high refractive index range of wavelengths on a long-wave side of the peak wavelength of the absorption wavelengths, and this range of wavelengths may preferably conform to the emission wavelength of the light emitting element. To that end, the wavelengths λa at which the dye has absorption may preferably be shorter than the center wavelength λc of the light emitting element (λa<λc). The difference between λa and λc may preferably be 10 nm or more, more preferably 25 mn or more, and still more preferably 50 nm or more. If λa and λc are too approximate, the range of absorption wavelengths of the dye overlaps the center wavelength λc of the light emitting element, so that light is absorbed. Further, the upper limit of the difference between λa and λc may preferably be 500 nm or less, more preferably 300 nm or less, and still more preferably 200 nm or less. If the λa and λc are too widely different, the refractive index would be too small for the light emitted from the light emitting element.

The wavelength λw of the laser beam to be emitted to form the recessed portions 15 may preferably satisfy a relationship as given by λa<λw. This relationship, if satisfied, allows the amount of light absorbed in the dye to fall into an adequate range, so that the recording efficiency can be improved and a fine pattern of pits and projections can be formed. Further, the relationship of λw<λc may preferably be satisfied. Since λw should be a wavelength such that light having this wavelength is absorbed by the dye, the light emitted from the light emitting element, which has the center wavelength λc located on the long-wave side of the wavelength λw, would not be absorbed by the dye, and thus transmissivity is improved with the result that the luminous efficiency is improved.

In view of the above, it is most preferable that the relation of λa<λw<λc is satisfied.

The wavelength λw of the laser beam to be emitted to form the recessed portions 15 may be any wavelength as long as a sufficiently high laser power is obtained. For example, in the case where a dye is used for the recording material layer 12, the wavelength may preferably be 1,000 nm or less, such as 193 nm, 210 nm, 266 nm, 365 nm, 405 nm, 488 nm, 532 nm, 633 nm, 650 nm, 680 nm, 780 nm, and 830 nm.

The laser beam may be of any known type such as gas laser, solid-state laser, and semiconductor laser. However, in order to simplify the optical system, the use of the solid-state laser or the semiconductor laser is preferable. The laser beam may be a continuous light beam or pulsed light beam. However, it is preferable to use a laser beam whose emission intervals can be changed freely. For example, the use of a semiconductor laser is preferable. In the case where the laser beam is not directly on-off keyed, it is preferable that the laser beam is modulated using an external modulation element.

In order to increase the processing speed, a higher laser power is preferable. However, the higher the laser power, the higher scanning speed (speed for scanning the recording material layer 12 with the laser beam; for example, rotation speed of the optical disc drive which will be described later) is required. For this reason, taking the upper limit value of the scanning speed into consideration, the upper limit value of the laser power is preferably 100 W, more preferably 10 W, and still more preferably 5 W, and most preferably 1 W. Meanwhile, the lower limit value of the laser power is preferably 0.1 mW, more preferably 0.5 mW, and still more preferably 1 mW.

It is preferable that the laser beam has a narrow range of oscillation wavelength and a high coherency, and that the laser beam can be condensed to a spot size which is as small as the wavelength of the laser beam. Further, as a recording strategy (*i*.*e*., optical pulse illumination conditions for appropriately forming recessed portions 15), it is preferable that the strategy used for optical discs is employed. To be more specific, conditions required for the manufacture of optical discs, such as recording speed, peak value of the illuminating laser beam, and pulse width, are preferably used.

It is preferable that the recording material layer 12 has a thickness set in accordance with the depth of the recessed portion 15 which will be described later.

This thickness may be set appropriately, for example, in the range of 1-10,000 nm.
The lower limit of the thickness is preferably 10 nm or more, and more preferably 30 nm or more. This is because, if the thickness is too thin, a recessed portion 15 formed is so shallow that optical effects can not be obtained. Further, in the case where the recording material layer 12 is used as an etching mask as will be described later, a desired effect as an etching mask can hardly be achieved. Meanwhile, the upper limit of the thickness is preferably 1,000 nm or less, and more preferably 500 nm or less. This is because, if the thickness is too thick, the required laser power is increased, the difficulty comes up in deeply making a hole, and the processing speed is reduced.

Further, it is preferable that the thickness t of the recording material layer 12 and the diameter d of the recessed portion 15 has the following relationship. Namely, the upper limit value of the thickness t of the recording material layer 12 preferably takes a value to satisfy the relationship as given by t<10d, more preferably takes a value to satisfy t<5d, and still more preferably to satisfy t<3d. The lower limit value of the thickness of the recording material layer 12 preferably takes a value to satisfy the relationship as given by t>d/100, more preferably takes a value to satisfy t>d/10, and still more preferably to satisfy t>d/5. The reason for determining the upper limit value and the lower limit value of the thickness t of the recording material layer 12 in accordance with the diameter d of the recessed portion 15 is the same as those described above.

It is preferable that the upper limit value of the diameter d of the recessed portion is 100,000 nm or less, more preferably 10,000 nm or less, and still more preferably 1,000 nm or less. It is preferable that the lower limit value thereof is 10 nm or more, preferably 50 nm or more, and still more preferably 100 nm or more.

To form the recording material layer 12, a substance which will act as a recording material is dissolved or dispersed in an appropriate solvent to prepare a coating liquid. Thereafter, the surface of the light emitting surface 18 is coated with this coating liquid by a coating method such as spin coating, dip coating, and extrusion coating, so that the recording material layer 12 can be formed.

The barrier layer 13, which his optionally provided, is formed to protect the recording material layer 12 from damage under an impact, etc. Any material may be used to form the barrier layer 13 as long as it is a transparent material. Preferably, the barrier layer 13 is made of polycarbonate, cellulose triacetate, etc., and more preferably, the barrier layer 13 is made of a material whose moisture absorptivity is 5% or less at 23°C50%RH. Oxides and sulfides such as SiO₂, ZnS, and GaO may also be used.

The term "transparent" means that the material allows light emitted from the LED element 10 to pass therethrough (transmissivity: 90% or more).

The barrier layer 13 is formed as follows. Firstly, light curing resin which forms an adhesive layer is dissolved in an appropriate solvent to prepare a coating liquid. This coating liquid is then coated on the recording material layer 12 at a predetermined temperature to form a coating film, and a cellulose triacetate film (TAC film) obtained, for example, by plastic extrusion processing is laminated on the coating film. Finally, the laminated TAC film is illuminated with light so that the coating film is cured to provide the barrier layer 13. It is preferable that the TAC film contains an ultraviolet light absorber. The thickness of the barrier layer 13 is in the range of 0.01-0.2 mm, preferably in the range of 0.03-0.1 mm, and more preferably in the range of 0.05-0.095 mm.

A plurality of recessed portions 15 are formed in the recording material layer 12 and the barrier layer 13 at intervals. The recessed portion 15 is formed by illuminating a portion of the recording material layer 12 and the barrier layer 13 with condensed light to thereby cause deformation (including deformation effected by dissipation or vanishment) at the illuminated portion. It is preferable that the recessed portions 15 are formed in positions arranged densely in an area of the light emission surface 18 from which the light is emitted.

The principle on which the recessed portion 15 is formed is as follows.

When the recording material layer 12 (recording layer compound) is illuminated with a laser beam having a wavelength such that the material has light absorption (*i.e.,* the wavelength of light to be absorbed in the material), the laser beam is absorbed by the recording material layer 12, and then converted into heat to thereby increase the temperature at an illuminated portion of the recording material layer 12. This causes the recording material layer 12 to undergo chemical or/and physical change(s) such as softening, liquefaction, vaporization, sublimation and decomposition. The thus-changed material moves or/and dissipates, and the recessed portion 15 is formed. It is to be understood that the barrier layer 13 is a very thin layer, and thus the barrier layer 13 moves or/and dissipates together with the recording material layer 12 moving or/and dissipating. When the recessed portion 15 is formed in this way, part of the chemically or/and physically changed recording material layer 12 is left and remains as debris around the recessed portion 15.

As a method for forming recessed portions 15, any hitherto known method for forming pits in a write-once optical or WORM disc is applicable. To be more specific, for example, the known running OPC technique (e.g., Japanese Patent No. 3096239) can be applied in which a reflected light intensity of the laser beam that varies in accordance with the pit size is detected, and the output of the laser is regulated so that the reflected light intensity becomes constant to thereby form uniform sized pits.

It is preferable that vaporization, sublimation or decomposition of the recording material layer 12 (recording layer compound) as described above occurs at a high rate of change, that is, precipitously. To be more specific, the weight decrease rate obtained by a thermogravimetry differential thermal analysis (TG-DTA) instrument during vaporization, sublimation or decomposition of the recording layer compound is preferably 5% or more, more preferably 10% or more, and still more preferably 20% or more. Further, the slope of weight decrease (weight decrease rate per elevated temperature of 1°C) obtained by the thermogravimetry differential thermal analysis (TG-DTA) instrument during vaporization, sublimation or decomposition of the recording layer compound is preferably 0.1 %/°C or more, more preferably 0.2 %/°C or more, and still more preferably 0.4 %/°C.

The upper limit value of the transition temperature of the chemical change or/and the physical change such as softening, liquefaction, vaporization, sublimation, and decomposition is preferably 2,000°C or less, more preferably 1,000°C or less, and still more preferably 500°C or less. This is because if the transition temperature is too high, a higher laser power is required. The lower limit value of the transition temperature is preferably 50°C or more, more preferably 100°C or more, and still more preferably 150°C or more. This is because if the transition temperature is too low, the temperature gradient relative to that of the environment is so small that the shape of an edge of a hole is not formed clearly.

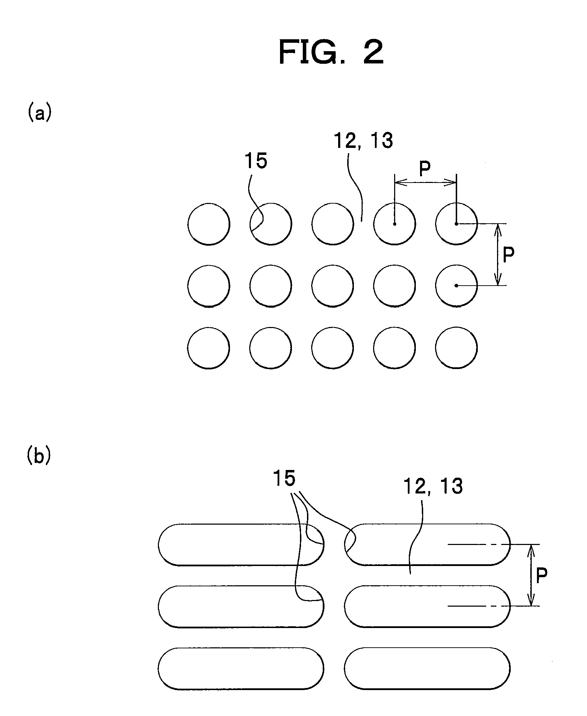

As shown in FIG. 2 (a), the recessed portions 15 may form a dotted pattern with each of the dots being arranged in a grid pattern. Further, as shown in FIG. 2 (b), the recessed portions 15 may be formed with a series of interspaced narrow grooves. Although not shown in the drawings, the recessed portions may be formed with continuous grooves, instead.

The pitch P of two adjacent recessed portions 15 is in the range of 0.01-100 times the center wavelength λc of light emitted from the LED element 10 which is the light emitting element.

The pitch P of the recessed portions 15 is preferably in the range of 0.05-20 times the center wavelength λc, more preferably in the range of 0.1-5 times the center wavelength λc, and most preferably in the range of 0.2-2 times the center wavelength λc. To be more specific, the lower limit value of the pitch P is preferably equal to or greater than 0.01 times the center wavelength λc, more preferably equal to or greater than 0.05 times the center wavelength λc, and further more preferably equal to or greater than 0.1 times the center wavelength λc, and most preferably equal to or greater than 0.2 times the center wavelength λc. Further, the upper limit value of the pitch P is preferably equal to or smaller than 100 times the center wavelength λc, more preferably equal to or smaller than 20 times the center wavelength λc, and further more preferably equal to or smaller than 5 times the center wavelength λc, and most preferably equal to or smaller than 2 times the center wavelength λc.

The recessed portion 15 has a diameter or a width of the groove in the range of 0.005-25 times the center wavelength λc, preferably in the range of 0.025-10 times the center wavelength λc, more preferably in the range of 0.05-2.5 times the center wavelength λc, and most preferably in the range of 0.25-2 times the center wavelength λc.

Herein, the diameter of the recessed portion 15 or the width of the groove of the recessed portion 15 indicates the size of the recessed portion 15 at a half of the depth thereof, which is a so-called half-value width.

The diameter of the recessed portion 15 or the width of the groove of the recessed portion 15 may appropriately be set in the above ranges. However, the diameter or the width is preferably adjusted in accordance with the size of the pitch P so that the refractive index becomes macroscopically gradually smaller as it is away from the light emission surface 18. In other words, it is preferable that if the pitch P is greater, the recessed portion 15 has a larger diameter or a larger width of the groove, and that if the pitch P is smaller, the recessed portion 15 has a smaller diameter or a smaller width of the groove. In this point of view, it is preferable that the diameter or the width of the groove is sized to be approximately a half of the pitch P. For example, the diameter or the width of the groove is preferably in the range of 20-80% of the pitch P, more preferably in the range of 30-70% of the pitch P, and most preferable in the range of 40-60% of the pitch P.

The depth of the recessed portion 15 is preferably in the range of 0.01-20 times the center wavelength λc, more preferably in the range of 0.05-10 times the center wavelength λc, further more preferably in the range of 0.1-5 times the center wavelength λc, and most preferably in the range of 0.2-2 times the center wavelength λc. The desirable upper limit value of the depth is 20,000 nm or less, preferably 10,000 nm or less, and more preferably 5,000 nm or less. The desirable lower limit value of the depth is 1 nm or more, preferably 5 nm or more, and more preferably 10 nm or more.

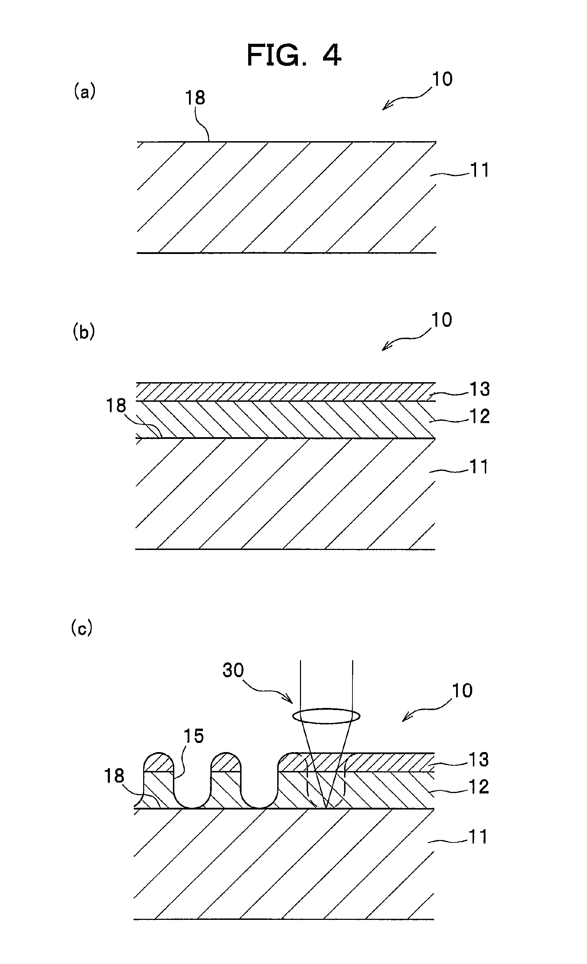

The method of manufacturing the LED package 1 configured as above will be described below with reference to FIGS. 4 (a)-(c).

As shown in FIG. 4 (a), a light emitting portion 11 as a main body of the LED element 10 is prepared, wherein the light emitting portion 11 is fabricated by a method known in the art. The light emitting portion 11 to be prepared here preferably has a size which does not correspond to a single LED element 10 but correspond to a plurality of LED elements 10 (*i.e.,* the light emitting portion 11 may be a wafer on which a plurality of LED elements 10 can be formed). In this configuration, after the wafer (light emitting portion 11) is processed to have pits and projections formed thereon, and is cleaned as will be described later, each of a plurality of light emitting portions 11 corresponding to the plurality of LED elements 10 will be separated from each other to obtain a plurality of LED elements 10.

After the light emitting portion 11 is prepared, a recording material layer 12 and a barrier layer 13 are formed in this sequence as shown in FIG. 4 (b).

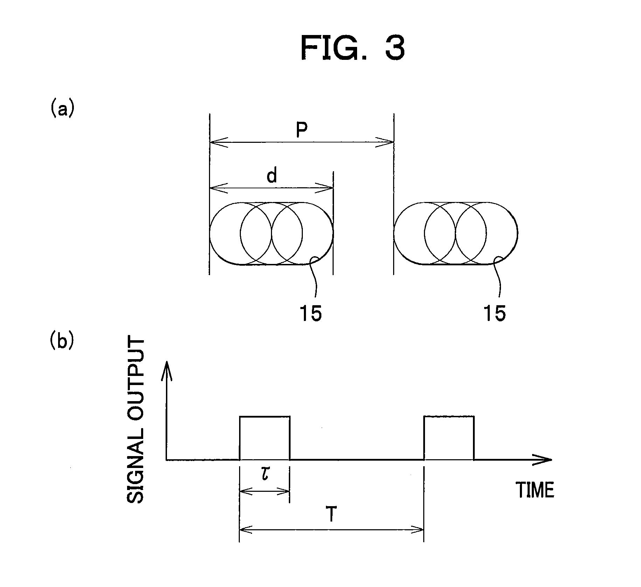

Next, recessed portions 15 are formed. As an apparatus for forming the recessed portions 15, any device having the same construction as that of an optical disc drive hitherto known in the art may be used. An example of the configuration of such an optical disc drive is disclosed, for example, in Japanese Laid-open Patent Application, Publication (JP-A) No. 2003-203348. With this type of optical disc drive, a wafer in which an LED element 10 is formed in a matrix pattern is formed in the same shape as that of the optical disc or it is attached to a dummy optical disc, so that the wafer is set on the spindle (not shown) in the disc drive. The recording material layer 12 is then illuminated with a laser beam at an output value appropriate to deform the material. Further, pulse signals or continuous signals are input to the laser light source such that the illumination pattern of the laser beam conforms with the dotted or grooved pattern of FIGS. 2 (a) or (b). As seen in FIG. 3 (b), the duty cycle of the laser beam emitted in a predetermined period T, which is defined by τ/*T* where τ indicates emission time and T indicates period, is preferably set smaller than the duty cycle of the actually formed recessed portions 15 *(i.e.,* length d of a recessed portion 15 in the laser beam scanning direction versus pitch P; *see* FIG. 3 (a)). It is noted that an oblong-shaped recessed portion 15 can be formed by moving the circle-shaped laser beam shown in FIG. 3 (a) at a predetermined speed during the emission time τ. For example, assuming that the length d of the recessed portion 15 is 50 while the pitch P of the recessed portion 15 is 100, it is preferable that laser beam is emitted at a duty cycle less than 50%. In this instance, the upper limit value of the duty cycle of the laser beam is preferably less than 50%, more preferably less than 40%, and still more preferably less than 35%. Meanwhile, the lower limit value of the duty cycle is preferably equal to or higher than 1%, more preferably equal to or higher than 5%, and still more preferably equal to or higher than 10%. It is possible to accurately form the recessed portion 15 having a predetermined pitch by setting the duty cycle as described above.

Further, a focusing method used in the optical disc drive known in the art may be also adopted. For example, by the use of an astigmatic method, the laser beam can be readily focused on the surface of the light emission surface 18 irrespective of a warpage or bent of the light emitting portion 11.

Accordingly, as shown in FIG. 4 (c), the LED element 10 is illuminated with the laser beam from the light emission surface 18 side which laser beam is condensed using an optical system 30 of the disc drive. Similar to the operation executed to record information on an optical recording disc, the light emitting portion 11 is rotated, and the optical system 30 is moved in a radial direction of the light emitting portion, so that the recessed portions 15 can be formed in the entire light emission surface 18.

The recessed portions 15 are formed under the processing conditions as follow.

Numerical aperture NA of the optical system 30 is set with a lower limit thereof being preferably 0.4 or more, more preferably 0.5 or more, and still more preferably 0.6 or more. Meanwhile, the upper limit of the numerical aperture NA is preferably 2 or less, more preferably 1 or less, and still more preferably 0.9 or less. If the numerical aperture NA is too small, a fine processing cannot be performed. If the numerical aperture NA is too large, a margin is decreased with respect to an angle at a time of recording.

The wavelength of the optical system 30 may be set, for example, to 405±30 nm, 532±30 nm, 650±30 nm, and 780±30 nm. These wavelengths are preferable to obtain a higher output. It is to be understood that a shorter wavelength is preferable because the shorter the wavelength, the finer the processing can be performed.

The output of the optical system 30 is set with a lower limit thereof being 0.1 mW or more, preferably 1 mW or more, more preferably 5 mW or more, and still more preferably 20 mW or more. The upper limit of the output of the optical system 30 is 1,000 mW or less, preferably 500 mW or less, and more preferably 200 mW or less. This is because if the output is too low, the processing takes too much time while if the output is too high, the durability of parts constituting the optical system 30 becomes deteriorated.

The linear velocity for relatively moving the optical system 30 with respect to the recording material layer 12 is set with a lower limit of the linear velocity being 0.1 m/s or higher, preferably 1 m/s or higher, more preferably 5 m/s or higher, and still more preferably 20 m/s or higher. Meanwhile, the upper limit of the linear velocity is 500 m/s or lower, preferably 200 m/s or lower, more preferably 100 m/s or lower, and still more preferably 50m/s or lower. This is because if the linear velocity is too high, it becomes difficult to execute processing with increased accuracy, whereas if the linear velocity is too low, the processing requires too much time and could not be performed enough to obtain an appropriate shape.

As a specific example of an optical processing apparatus including the optical system 30, NE0500 manufactured by Pulstec Industrial Co., Ltd. can be used.

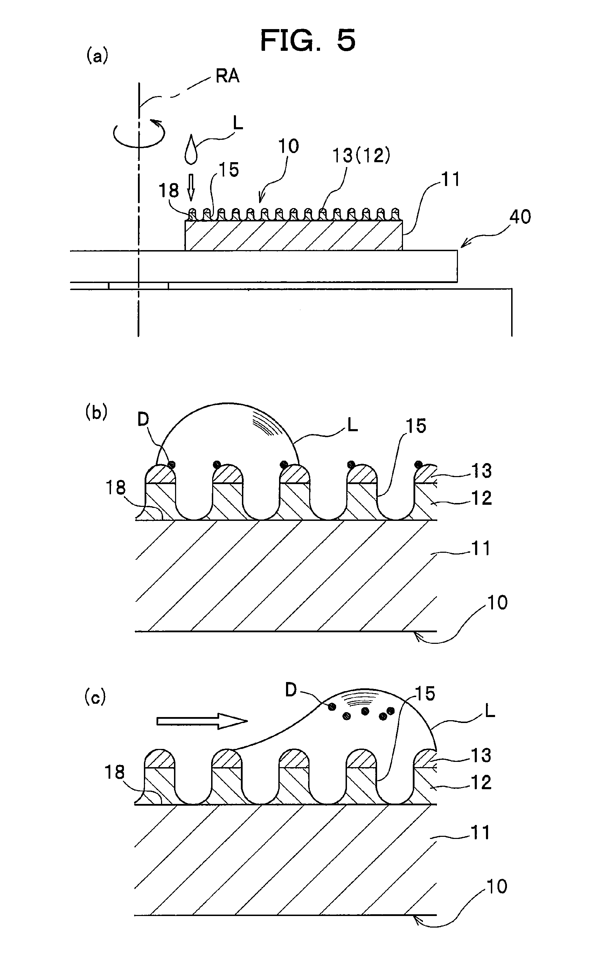

After the recessed portions 15 are formed in the recording material layer 12 and the barrier layer 13 as described above, a cleaning step as shown in FIGS. 5 (a)-(c) is performed. In FIG. 5 (a), the recessed portions 15 are illustrated in an exaggerated manner for the purpose of better understanding.

In the cleaning step, first, the substrate is turned, and a cleaning liquid is discharged onto the substrate being turned. In this step, the rotation speed may be set preferably in the range of 20-700 rpm, more preferably in the range of 50-500 rpm, and still more preferably in the range of 100-400 rpm. Thereafter a drying step is performed in which the rotation speed may be set preferably in the range of 500-10,000 rpm, more preferably in the range of 1,000-7,000 rpm, and still more preferably in the range of 2,000-5,000 rpm.

The amount of discharged cleaning liquid may be preferably in the range of 0.1-500 ml, more preferably in the range of 1-200 ml, and still more preferably in the range of 5-50 ml. This amount of cleaning liquid may be discharged preferably for a period of 0.1-1,000 seconds, more preferably for a period of 1-200 seconds, and still more preferably for a period of 5-100 seconds.

The applicable cleaning method other than this spin cleaning may include a dip cleaning, a spray cleaning, a plasma cleaning, and other methods conceivable. However, the spin cleaning may be preferable.

After the recessed portions 15 are formed, the LED element 10 is removed from the optical processing apparatus, and set in a device 40 for spin coating as shown in FIG. 5 (a). Then, the device 40 is actuated; that is, while the LED element 10 is being turned along its surface (light emission surface 18), a liquid L which is inactive to the light emitting portion 11, the recording material layer 12 and the barrier layer 13 is dropped (supplied) on a spot on the LED element 10 which spot is located on a device 40 spindle RA side. Thus, as shown in FIGS. 5 (b), (c), the liquid L dropped on the light emission surface 18 of the LED element 10 moves from the spindle RA side (*see* FIG. 5 (a)) outward by the centrifugal force, and debris D adhered to the recording material layer 12 and other components are washed away to the outside by this moving liquid L.

The liquid L which contains at least one of hydrocarbon solvents, fluorinated solvents and water may preferably be adopted. Examples of the hydrocarbon solvents which can be used may include, for example, octane, nonane, toluene, xylene, n-hexane, isohexane, cyclohexane, methylcyclohexane, n-heptane, isoheptane and decane. Examples of fluorinated solvents which can be used may include, for example, a hydrofluoroether (manufactured by 3M Company). Examples of mixed solvents which can be used may include, for example, solvent naphtha, EM-Clean (registered trademark, manufactured by The Japan Energy Corporation), NS-Clean (registered trademark, manufactured by The Japan Energy Corporation), and HC-Series (Tosoh Corporation). The solvents may be used alone or in mixture.

The boiling point of the solvent may preferably be selected appropriately from a predetermined range. This range may be set with a lower limit value preferably of 30 degrees centigrade, more preferably of 50 degrees centigrade, and most preferably of 70 degrees centigrade. By setting the lower limit value as above, the instantaneous vaporization of the cleaning liquid which would result in failure to achieve cleaning effects can be prevented. The upper limit value of the range may be set preferably at 300 degrees centigrade, more preferably at 200 degrees centigrade, and most preferably 150 degrees centigrade. By setting the upper limit value as above, the solvent can be quickly vaporized after cleaning, and the productivity can be improved.

In order to maintain the fine pattern on the recording material layer 12 during cleaning by the liquid L, the liquid L may preferably be selected from the hydrocarbon solvents. It is particularly preferable that octane and nonane be adopted.

Examples of the device 40 for spin coating may include, for example, MS-A100 (Mikasa Co., Ltd.).

The period of time elapsing from the time at which the recessed portions 15 have been formed before starting the removal of debris D (spin coating) may be set preferably in the range of 0.1 second to 72 hours. The lower limit value of the period of time elapsing from the time at which the recessed portions 15 have been formed before starting the removal of debris D may be preferably 1 second or longer, more preferably 10 seconds or longer, and most preferably 100 seconds or longer. The lower limit value, if set as above, makes it possible to sufficiently cool the recording material layer 12 and other components in which the recessed portions 15 are formed, with the result that the disturbance of the shapes of the recessed portions 15 which would be generated by putting the liquid L on the high-temperature recording material layer 12 and other components can be suppressed. The upper limit value of the period of time elapsing from the time at which the recessed portions 15 have been formed before starting the removal of debris D may be preferably 24 hours or shorter, more preferably 1 hour or shorter, and most preferably 10 minutes or shorter. The upper limit value, if set as above, makes it possible to prevent the debris D from being fixed on the recording material layer 12 or other components due to a long period of time during which the debris D left unremoved, so that the debris D can be removed effectively by the liquid L.

The amount of the liquid L to be dropped may be preferably 0.5-20 cc, and more preferably 1-5 cc. The lower limit value, if set as above, makes it possible to wash away the debris D by the liquid L without fail; the upper limit value, if set as above, makes it possible to shorten a period of time for drying after removal of the debris.

After the debris D are washed away by the liquid L as described above, the rotation is continued for a predetermined period of time, and the liquid L having remained on the LED element 10 is all swept away, so that the LED element 10 is dried quickly.

Thereafter, though not shown in the drawings, the LED element 10 is fixed in the case 20, and necessary wirings are provided; in this way, the LED package 1 is manufactured.

The LED package 1 formed as described above has a fine pattern of pits and projections formed in the light emission surface 18 thereof, and thus the refractive index changes macroscopically and gradually in the vicinity of the light emission surface 18; therefore, it is possible to restrict light emitted from the light emission surface 18 from being reflected by the inner surface of the light emission surface 18. This can improve the luminous efficiency of the LED package 1.

As described above, the recording material layer 12 can be formed all at once in large quantities by means of coating, or like method, and thus the recessed portions 15 can be formed swiftly and inexpensively using an apparatus which is similar in structure to the conventionally known optical disc drive. Further, a known focusing method can be adopted so that the recessed portions 15 can be formed in a simple manner irrespective of a warpage of the material. This manufacturing process is very simple when compared with a method requiring a development step using a photoresist or a conventional complicated method including application of the material, baking, exposure, baking, and etching. Therefore, it is possible to simply form a fine pattern of pits and projections in the light emission surface of the light emitting element so as to improve the luminous efficiency.

Since debris D adhered to the recording material layer 12 or other components are removed by the liquid L, a neat pattern of pits and projections (recessed portions 15) can be formed.

Since the liquid L is distributed evenly all over the entire surface of the LED element 10 by merely dropping the liquid L on the spindle-side spot of the LED element 10, the amount of the liquid L to be applied can be reduced. Moreover, since application of the liquid L all over the entire surface of the LED element 10 and the removal of debris adhered to the recording material layer 12 or other components are achieved at the same time by the rotation causing the liquid L to move, the cleaning time can be shortened.

Since the rotation is continued after debris D have been washed away from the recording material layer 12 or other components so as to perform the drying operation, the recording material layer 12 and other components can be dried more swiftly in comparison with the air-drying method where the rotation is stopped after debris have been washed away. Furthermore, since the present embodiment adopts the spin coating method as a method for application, the operations of application through drying can be carried out by the same device 40, with the result that the facilities can be simplified.

Because the LED element 10 is transferred from the optical processing apparatus to another device 40 for spin coating before the recording material layer 12 and other components are cleaned, the recessed portion forming step and the cleaning step can be carried out in parallel, and thus the performance or capability (throughput) of processing can be increased. Furthermore, by transferring the LED element 10 from the optical processing apparatus to another device 40 for spin coating as described above, the splatter of the cleaning liquid on the surface of the lens of the optical processing apparatus in the cleaning step can be prevented.

### [SECOND EMBODIMENT]

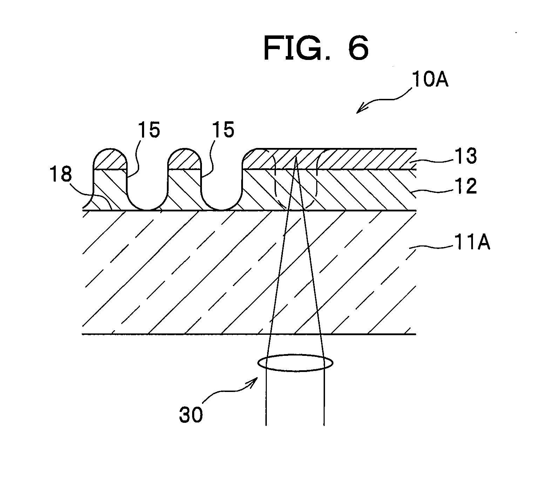

A method for manufacturing an optical element according to a second embodiment of the present invention will be described with reference to FIG. 6.

An optical element 10A is a member with a high transmissivity for light, and is closely-attached or adhered to the light emission surface of the light emitting element. For example, the optical element 10A is attached to the surface of the light emission surface 18 of the LED package 1 which has been exemplified in the first embodiment or to the surface of a fluorescent tube.

As shown in FIG. 6, the optical element 10A is configured such that a recording material layer 12 and a barrier layer 13 which are similar to those described in the first embodiment are formed on a transparent supporting member 11A and recessed portions 15 are formed.

The supporting member 11A may have a sufficient transmissivity (e.g., transmissivity of approximately 80% or more) with respect to light emitted from the light emitting element. The supporting member 11A is made of resin such as polycarbonate, or a glass material.

In order to form the recessed portions 15, the supporting member 11A is moved and a laser beam is condensed as in the first embodiment so that the supporting member 11A is illuminated with a pulsed laser beam. In this instance, as shown in FIG. 6, the optical element 10A may be illuminated with the laser beam from the supporting member 11 A side (opposite side of the recording material layer 12). In the case where the laser beam is emitted from the side opposite to the recording material layer 12, the laser beam source is advantageously free from being soiled by ejected material that is spewed out from the recording material layer 12 upon reaction with the laser beam.

After the recessed portions 15 are formed, debris D adhered to the recording material layer 12 or other components are removed by the cleaning method similar to that of the first embodiment.

The optical element 10A configured as above is attached to the surface of the light emission surface 18 of the LED package 1 or to the surface of the fluorescent tube, so that the luminous efficiency of these light emitting elements can be improved.

### [THIRD EMBODIMENT]

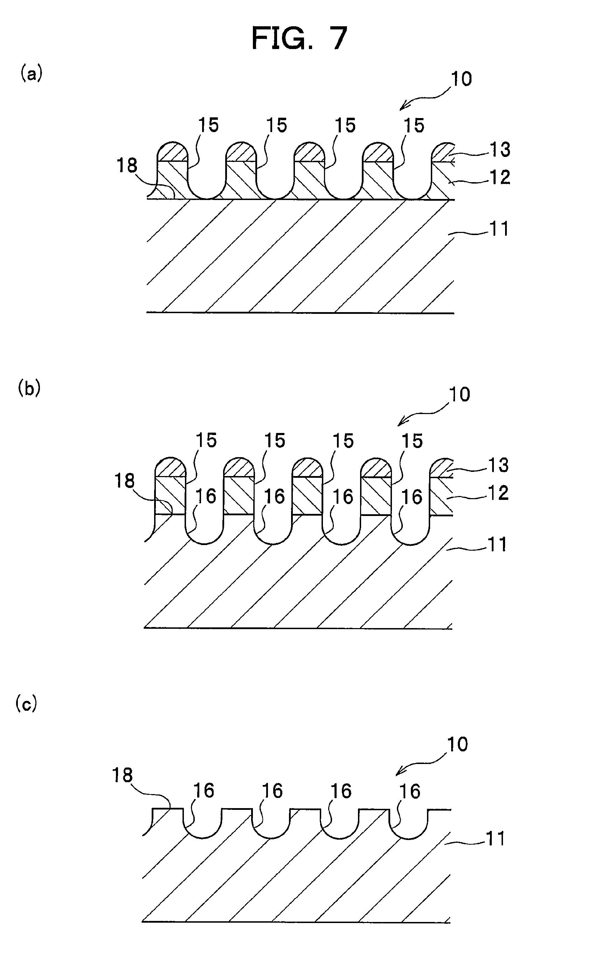

A method of manufacturing a light emitting element according to a third embodiment of the present invention will be described with reference to FIGS 7 (a)-(c).

In the method for manufacturing an LED element 10 according to the third embodiment, recessed portions 15 are formed in the recording material layer 12 and the barrier layer 13 as shown in FIG. 7 (a) by the same process steps as described in the first embodiment (*see* FIGS. 4 and 5), and the recording layer material 12 and other components are cleaned by the liquid L. Thereafter, etching is performed while the recording material layer 12 and the barrier layer 13 in which the recessed portions 15 are formed are used as a mask, so that a plurality of holes 16 corresponding to the recessed portions 15 are formed in the light emission surface 18 as shown in FIG. 7 (b). Finally, as shown in FIG. 7 (c), the recording material layer 12 and the barrier layer 13 are removed using a predetermined stripping agent or the like, so that the light emission surface 18 with a fine pattern of pits and projections is exposed to view.

Various etching methods can be adopted, such as wet etching and dry etching.
However, RIE is preferable because an etching gas tends to travel in a straight line so that fine patterning can be performed. Further, removal of the recording material layer 12 and the barrier layer 13 may be carried out by various methods including a dry process and a wet process.

As a specific example for the etching method and the removal method, for example, in the case where a layer including the light emission surface 18 of the light emitting portion 11 is made of glass, the recording material layer 12 contains dye, and the barrier layer 13 is made of an inorganic material layer, RIE using SF6 as an etching gas and a wet removal process using ethanol as a stripping agent may be adopted. Herein, the term "layer including the light emission surface" indicates any layer as long as it forms a surface boundary with respect to the external environment such as gas (*e*.*g*. air) and liquid (e.g. water) after manufacture of the LED element 10.

According to the manufacturing method in this third embodiment, since pits and projections are formed in the surface (light emission surface 18) itself of the LED element 10, it is possible to simply design a pattern of pits and projections without consideration of the refractive index difference between the LED element 10 and the recording material layer 12. According to this embodiment, a plurality of recessed portions 15 are formed using, for example, the focusing technique, in the recording material layer 12, which has been formed in advance on the surface of the LED element 10, so that a mask is reliably set in close contact with the surface of the LED element 10. Therefore, the manufacturing method according to this embodiment is free from a drawback of the conventional manufacturing method that a mask does not closely contact with the surface of the LED element 10 because of warpage or bent of the surface of the LED element 10. Therefore, the pattern of pits and projections can be formed easily.

Although some embodiments of present invention has been described, the present invention is not limited to these embodiments and various changes and modifications may be made where appropriate.

For example, in the above embodiments, the LED element is shown as an example of the light emitting element. However, the light emitting element is not limited to the LED element and may be any light emitting device such as a plasma display element, a laser, an SED element, a fluorescent tube, and an EL element.

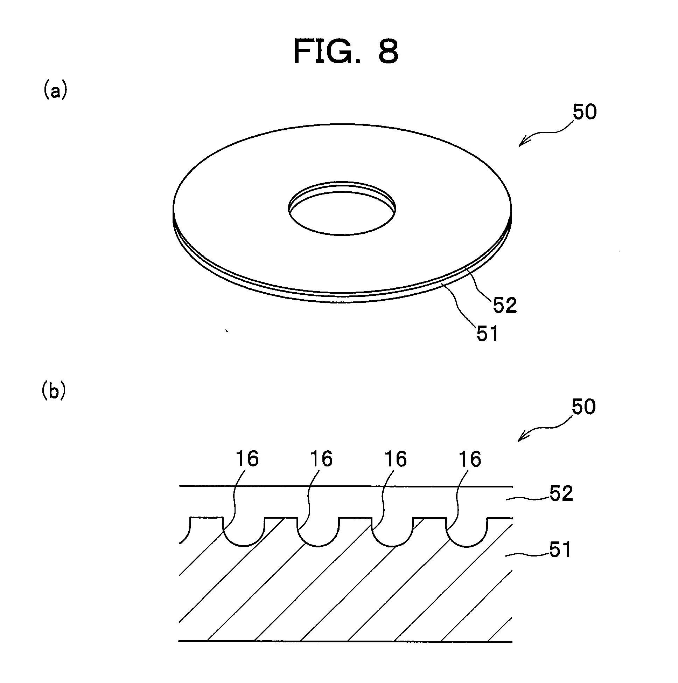

In the respective embodiments described above, a cleaning method according to the present invention is applied to the methods for manufacturing a light emitting element or an optical element. The present invention is not limited to these embodiments; the present invention may be applied to a method for manufacturing a pit-projection product. That is, as shown in FIGS. 8 (a) and (b), the present invention may be applied to a method for manufacturing an optically readable information recording medium (optical disc 50) as an example of the pit-projection product, by forming holes 16 as information on a substrate (base) 51 made of an inorganic substance and providing a protective layer 52 at a side of the substrate 51 on which the holes 16 are formed. To be more specific, a recording material layer 12 and a barrier layer 13 are formed on the substrate 51, and recessed portions 15 are formed by applying condensed light to the recording material layer 12 and other layer, by the same method as the method shown in FIG. 4. Subsequently, debris adhered onto the substrate 51 are cleaned by liquid by the same method as the method shown in FIG. 5. Thereafter, holes 16 corresponding to the recessed portions 15 are formed, using the recording material layer 12 and other layer as a mask, by the same method as the method shown in FIG. 7. In this way, the holes 16 can be neatly formed in the substrate 51.

Materials for the substrate 51 may preferably be selected from those containing Si or Al; for example, Si, SiO₂, Al₂O₃ and the like may be preferably adopted. Materials for the protective layer 52 may preferably be selected from inorganic materials such as SiO₂ or other inorganic oxides and Si₃N₄ or other inorganic nitrides, and organic materials such as UV curing resins, which may be adopted alone or in combination. For the purpose of extending the longevity of the optical disc 50, however, it would be desirable that the protective layer 52 also be formed from an inorganic material.

The pit-projection product is not limited to the optical disc 50, but includes semiconductors, flat panel displays (organic electro-luminescence, liquid crystal and plasma displays), SEDs (surface-conduction electron-emitter displays), circuit boards, masks for light exposure, semiconductors and packages thereof, interposers, printed boards, storage media, bio chips, and the like.

As means for mass production of pit-projection products having fine pits and projections formed densely, the nanoimprint technology has been a focus of study. The nanoimprint technology is a field of art in which a press work using a mold or die is applied to a nanoscale production, and refers to a nanoscale molding work technique in which a mold having fine pits and projections is pressed against a workpiece to impart a desired shape. With the nanoimprint technology, a pattern of several tens of nanometer width can be formed. Compared with the relevant working technique using an electron beam, the nanoimprint technology is advantageous in that molding work can be achieved at low cost and in large quantity. The above-described method using a heat mode resist material may be adopted for the method of forming fine pits and projections in a mold for use in the nanoimprint technology application.

In the above embodiments, the recording material layer 12 is directly provided on the light emission surface of the light emitting element or the optical element, or the surface of the substrate 51 which makes up an optical disc 50. However, another material may be interposed between the light emission surface or the surface and the recording material layer 12. In the case where a protective layer or/and a lens is provided on the surface of the LED element consisting of a semiconductor, the surface (surface boundary to air) of the protective layer or the lens becomes a light emission surface. In this instance, the recording material layer 12 and the recessed portions 15 may be provided on the surface of the protective layer or the surface of the lens.

In the above embodiments, the recessed portions 15 are formed using a laser beam. However, as long as light can be condensed to a required size, another kind of light, other than a monochromatic light such as a laser beam, may be used.

In order to obtain the minimum processing shape, the laser beam is emitted at infinitesimally small time intervals. The diameter of the recessed portion formed by the laser beam is preferably smaller than the wavelength of the laser beam. In other words, it is preferable that the laser beam is condensed to have a smaller spot diameter which satisfies the above relationship.

When a recessed portion 15 having a size larger than that of the minimum processing shape (hereinafter referred to as a "laser spot") is to be formed, laser spots may be connected to provide a larger recessed portion 15. It is noted that when the heat mode-type recording material layer 12 is illuminated with the laser beam, a change of the recording material occurs only in a part of the illuminated portion which reaches the transition temperature. Since the light intensity is greatest at the center in cross section of the laser beam and is gradually attenuated toward the edge of the laser beam, a minute hole (laser spot) having a diameter smaller than the spot diameter of the laser beam can be formed in the recording material layer 12. When a recessed portion 15 is formed with such fine holes arranged contiguously, the precision in the shape of the recessed portion 15 can be increased. On the other hand, if a photon mode-type material is employed, its reaction occurs in the whole illuminated portion
where the laser beam strikes the surface thereof. Therefore, the size of the hole (*i.e.,* laser spot) formed by a single pulse of the laser beam is relatively large, and the precision in its shape would be diminished in comparison with the cases where a heat mode-type material is employed. In this respect, the heat mode-type material as used in the present invention is preferable.

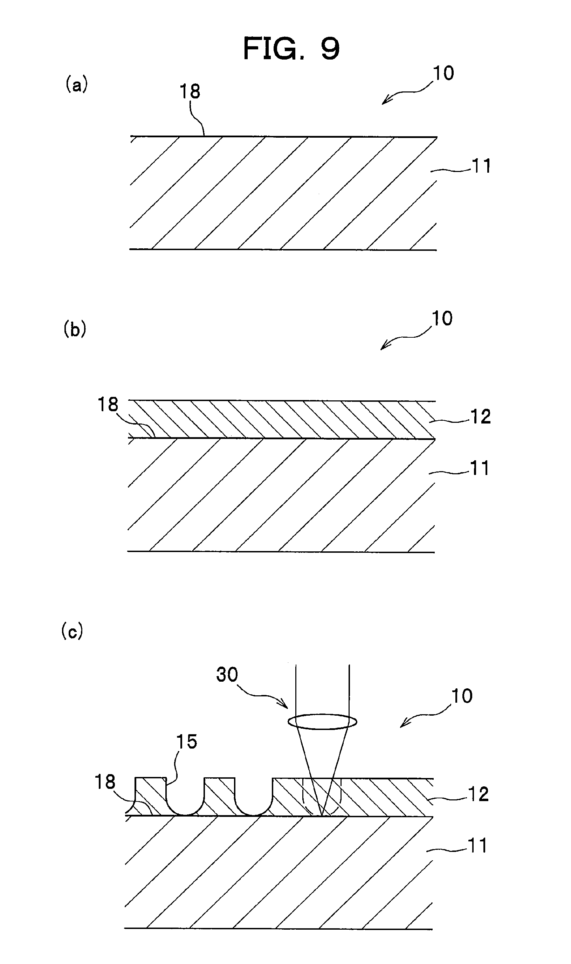

In the above-described embodiments, the barrier layer 13 is formed on the recording material layer 12. However, the present invention is not limited to this configuration, and the barrier layer 13 may not be provided, as shown in FIG. 9. Especially, if the recording material layer 12 is used as an etching mask as in the third embodiment or as in the embodiment shown in FIG. 8, it may be preferable that the barrier layer 13 be omitted.

According to the third embodiment described above, holes 16 are formed in the surface of the LED element 10. However, the present invention is not limited to this configuration, and holes may be formed in the surface of the optical element 10A (surface of the supporting member 11A) as described in the second embodiment by employing the recording material layer 12 or other layer as an etching mask.

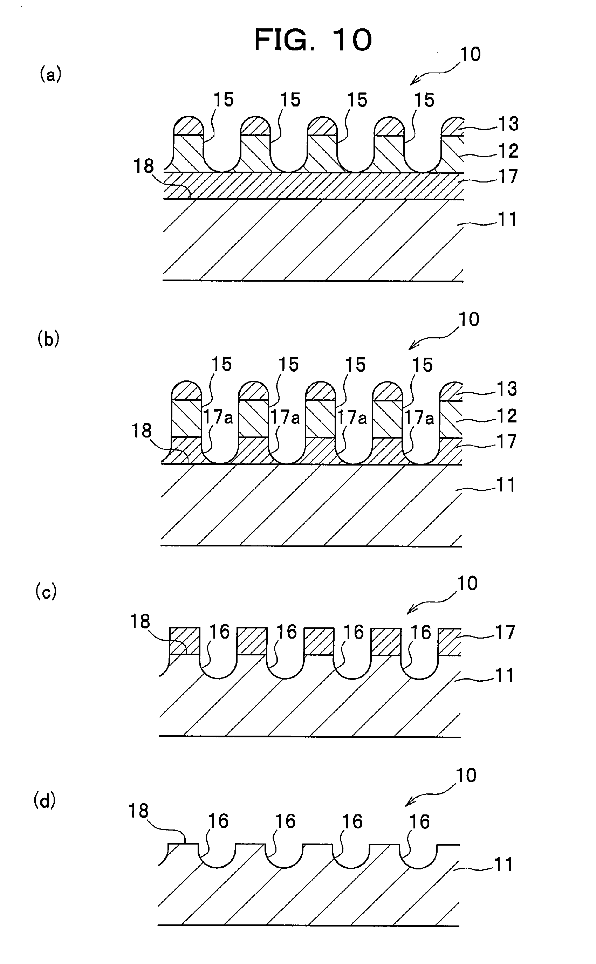

In the third embodiment described above or the embodiment shown in FIG. 8, the recording material layer 12 and other layer are formed, as an etching mask, directly on the surface in which the holes 16 are to be formed *(i.e.,* the light emission surface 18 or the surface of the substrate 51), but the present invention is not limited to this configuration. For example, if the recording material layer 12 and other layer are easily stripped by an etching gas, a mask layer 17 which can be subjected to etching by an etching gas substantially insusceptible to the recording material layer 12 and other layer may be provided, as shown in FIG. 10 (a), between the light emission surface 18 and the recording material layer 12. It is to be understood that FIG. 10 exemplifies one embodiment in which holes 16 are formed in the light emission surface 18, but a mask layer 17 may be provided similarly in another embodiment in which holes 16 are formed in the surface of the substrate 51.

According to this configuration, first, as in the first embodiment, recessed portions 15 are formed by a laser beam in the recording material layer 12 and the barrier layer 13, and the recording material layer 12 and other layer are cleaned by a liquid L (*see* FIG. 10 (a)). Next, as shown in FIG. 10 (b), the mask layer 17 is subjected to etching by a first etching gas to form through holes 17a corresponding to the recessed portions 15, in the mask layer 17. In this step, since a particular type of gas such that the recording material layer 12 and the barrier layer 13 are not stripped thereby is selected as the first etching gas, the mask layer 17 is subjected to etching with the recording material layer 12 and the barrier layer 22 serving as a mask.

Thereafter, as shown in FIG. 10 (c), the layer having the light emission surface 18 is subjected to etching by a second etching gas, so that holes 16 corresponding to the recessed portions 15 are formed on the light emission surface 18. During this process, the recording material layer 12 and the barrier layer 13 subjected to etching by the second etching gas are removed promptly; however, the light emission surface 18 can be etched successfully and excellently because the mask layer 17 serves as a mask. Thereafter, as shown in FIG. 10 (d), the mask layer 17 is removed by using a predetermined stripping agent or the like, so that the light emission surface 18 having pits and projections formed thereon is exposed to view.

As a specific example of the configuration shown in FIG. 10, a Si-containing Bi-Layer photoresist manufactured by TOKYO OHKA KOGYO CO., LTD. may be employed as the mask layer 17, SF6 may be used as the first etching gas, and Cl₂ may be used as the second etching gas, for example, in the case where the layer including the light emission surface 18 of the light emitting portion 11 is made of sapphire, the recording material layer 12 contains dye, and the barrier layer 13 is made of an inorganic material layer.

In the embodiments described above, a liquid L for cleaning is applied to the surface of the recording material layer 12 and other layer by spin coating, but the present invention is not limited to this configuration; any methods may be adopted which include, for example, spray coating, die coating, dip coating, etc. After the liquid is applied to the surface of the recording material layer 12 and other layer by any of these application methods, a workpiece (a product to be worked, having a recording material layer 12 or other layer) may be turned so as to move the liquid as in the embodiment described above, so that debris are washed away from the surface. In the dip coating, when a workpiece is dipped in a liquid, the workpiece may be moved in a liquid so that debris on the surface may be washed away.

In the embodiments described above, a workpiece is turned to dry the surface of the workpiece, but the present invention is not limited to this configuration; for example, the surface may be allowed to air-dry, or dried by blowing air with the help of a blower.

In the embodiments described above, the device for application of a liquid L and drying is provided in addition to the optical processing apparatus, but the present invention is not limited to this configuration; the application of a liquid and drying may be performed by turning a workpiece in the optical processing apparatus. However, the configuration, according to the above-described embodiments, in which the device for application and drying is provided in addition to the optical processing apparatus, is preferable in that a processing head (light emitting surface) of the optical processing apparatus is prevented from being soiled by the liquid.

### EXAMPLE

One example implemented with which the advantageous effects of the present invention have been confirmed will be described below.

In the implementation example, a dye-containing layer (recording material layer) having a thickness of 100 nm was formed on a disc-shaped substrate (supporting member), and recessed portions were formed in a radius range of 25 mm to 40 mm of the substrate, by the laser beam, sequentially from a radially inner side at a radial pitch of 0.1 mm and at a circumferential pitch of 1 µm. After the recessed portions were formed, the surface of the dye-containing layer was cleaned, and pits and projections were formed in the substrate by dry etching.

Details of each layer were as follows.

### - Substrate

| Material: | Silicon |
|---|---|
| Thickness: | 0.5 mm |
| Outer diameter: | 101.6 mm (4 inch) |
| Inner diameter: | 15 mm |

### - Dye-containing layer (Recording material layer)

2 g of the dye-containing material given by the following formula was dissolved in 100 ml of TFP (tetrafluoropropanol) solvent, and the resulting solution was spin coated. In this spin-coating process carried out with a dispense-start rotation speed of 500 rpm and a dispense-end rotation speed of 1,000 rpm, a coating liquid was dispensed onto the inner-radius area of the substrate, and the rotation speed was gradually increased to 2,200 rpm. The refractive index n of the dye-containing material was 1.986 and the extinction coefficient k of the dye-containing material was 0.0418.

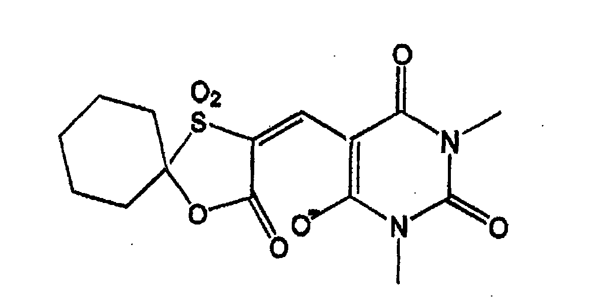

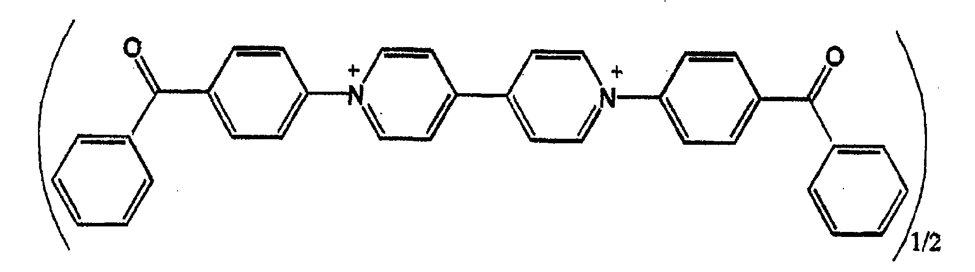

In the above optical recording medium, fine recessed portions were formed from the dye-containing layer side using DDU1000 (wavelength: 405 nm, NA: 0.65) manufactured by Pulstec Industrial Co., Ltd., in which a spherical aberration corrector plate is provided.

Conditions for forming the recessed portions were as follows.

| | |
|---|---|
| Laser output: | 2.5 mW |
| Linear velocity: | 5 m/s |
| Recording signal: | Square wave of 5 MHz |

After the recessed portions were formed, the rotation speed of the spindle of the aforementioned device was set at 300 rpm, and octane was dropped on a spot at about 20 mm radius of the substrate. To be more specific, 3 cc of octane was dropped for 3 seconds on the substrate. After completion of the dropping of octane, the rotation speed of the spindle is increased to 1,000 rpm and the substrate was rotated for 20 seconds, and thereafter the rotation speed of the spindle is further increased to 2,000 rpm and the substrate was rotated for 20 seconds so that the substrate was dried.

After the substrate was dried, pits and projections were formed in the substrate by dry etching (RIE) using the dye-containing layer as a mask, and the dye-containing layer was removed by a stripping liquid. The conditions of the dry etching were as follows:

| | |
|---|---|
| Etching gas: | SF6+CHF3 (1:1) |
| Stripping liquid: | Ethanol |

The surface of the substrate manufactured as described above was observed by SEM (scanning electron microscope). As a comparative example, a substrate was fabricated without performing the cleaning step as described above, by forming a dye-containing layer, forming recessed portions in the dye-containing layer and performing dry etching using the dye-containing layer as a mask; the surface of the substrate was observed by SEM.

As a result, in the implementation example, it was shown that holes having a diameter of approximately 0.3 µm were formed substantially uniformly in the radius range of 25 to 40 mm of the substrate. On the other hand, in the comparative example, it was shown that the area in the radius range of 25 to 40 mm of the substrate had a portion in which no holes were formed. Accordingly, it was proved that the cleaning of the substrate contributed to the formation of neatly shaped pattern of pits and projections on the substrate.

## Claims

1. A method for cleaning a heat mode type recording material layer to remove debris generated when a plurality of recessed portions are formed in a thermally deformable heat mode recording material layer by application of condensed light, which comprises:
using a liquid inactive to the recording material layer, to thereby remove the debris.

2. The method for cleaning a heat mode type recording material layer according to claim 1, wherein a period of time elapsing from a time at which the recessed portions have been formed to a time at which removal of the debris is started is in the range of 0.1 second to 72 hours.

3. The method for cleaning a heat mode type recording material layer according to claim 1, wherein the liquid contains at least one of hydrocarbon solvents, fluorinated solvents and water.

4. The method for cleaning a heat mode type recording material layer according to claim 1, which comprises supplying the liquid onto the recording material layer, and thereafter turning the recording material layer along a surface thereof, thereby washing the debris away from inside to outside of the recording material layer by the liquid.

5. The method for cleaning a heat mode type recording material layer according to claim 4, which comprises continuing to turn the recording material layer after washing the debris away, thereby drying the recording material layer.

6. The method for cleaning a heat mode type recording material layer according to claim 1, which comprises supplying the liquid onto part of the recording material layer while turning the recording material layer along a surface thereof, thereby washing the debris away from inside to outside of the recording material layer by the liquid.

7. The method for cleaning a heat mode type recording material layer according to claim 6, which comprises continuing to turn the recording material layer after washing the debris away, thereby drying the recording material layer.

8. A method for manufacturing a pit-projection product having pits and projections on a surface of a substrate, comprising the steps of:
forming a thermally deformable heat mode recording material over the surface of the substrate;
forming a plurality of recessed portions in the recording material layer by applying condensed light thereto;
removing the debris by the cleaning method according to any one of claims 1 to 7; and
forming holes corresponding to the recessed portions in the surface of the substrate by etching using the recording material layer as a mask.

9. A method for manufacturing a light emitting element with a luminous body, comprising the steps of:
forming a thermally deformable heat mode recording material over a light emission surface;
forming a plurality of recessed portions in the recording material layer by applying condensed light thereto; and
removing the debris by the cleaning method according to any one of claims 1 to 7.

10. The method for manufacturing a light emitting element according to claim 9, which comprises forming holes corresponding to the recessed portions in the light emission surface by etching using the recording material layer from which the debris have been removed, as a mask.

11. A method for manufacturing an optical element to be mounted over a light emission surface of a light emitting element to improve a luminous efficiency of the light emitting element, comprising the steps of:
forming a thermally deformable heat mode recording material layer over a surface of a supporting member which allows light emitted from the light emitting element to pass therethrough;
forming a plurality of recessed portions in the recording material layer by applying condensed light thereto; and
removing the debris by the cleaning method according to any one of claims 1 to 7.

12. The method for manufacturing an optical element according to claim 11, which comprises forming holes corresponding to the recessed portions in the surface of the supporting member by etching using the recording material layer as a mask.
